# EUROPEAN PATENT APPLICATION

(11) **EP 0 839 926 A1**
(43) Date of publication of application: **06.05.1998**
(21) Application number: 97308716.6
(22) Date of filing: 30.10.1997
(51) Int. Cl.: C23C 14/34, C23C 14/54

(54) **Sputtering processes and apparatus**

(30) Priority: 04.11.1996 GB 9622913
(71) Applicant: The BOC Group plc, Windlesham Surrey GU20 6HJ (GB)
(72) Inventor: Thwaites, Michael John, Hampshire, RG27 9PF (GB)
(74) Representative: Bousfield, Roger James

(57) **Abstract**

A process for coating a substrate by sputtering in a vacuum chamber from a target (2), which comprises forming a plasma in the chamber in the vicinity of the target and applying an electric charge to the target, wherein the target surface from which the sputtering takes place comprises a plurality of areas (6,7,8) of different composition and separate electrical connections (16) are made to each area to enable a variable electric charge to be applied to each individual area.

## Description

This invention relates to processes and apparatus for the sputtering of thin coatings on to a substrate and, more particularly, to the control of composition of the individual components of alloy coatings.

Cathode sputtering processes are widely used for depositing thin coatings or films of material on to substrates. Such processes are carried out in an evacuated chamber containing a small quantity of ionisable gas, for example argon; electrons emitted from a source held within the chamber ionise the gas to form a plasma and a negatively charged target comprising the material to be sputtered is bombarded by the ions attracted to its surface causing atoms of the target material to be dislodged and subsequently deposited as a film on the substrate being coated.

It is well known that in magnetron sputtering apparatus the rate of deposition may be increased by the use of magnetic means, for example an array of permanent magnets positioned in a predetermined manner - commonly as a closed loop array - associated with the cathode target and whose magnetic field defines an area or region of the target from which sputtering, or erosion of the target, predominantly occurs.

The target is commonly of flat, elongate and rectangular form; the substrate being coated is moved continuously or intermittently relative to the target during the sputtering process. Apparatus having such a target and having magnetic means of the type described above is known as a planar magnetron.

A disadvantage of the planar magnetron is that the area of the target from which erosion occurs substantially corresponds to the shape of the closed magnetic loop, commonly an elongate ring shape which is often referred to as the "race track". The race track area represents only a small portion of the total target surface and, as a result, there is considerable waste of target material when it is replaced.

It is also known, however, to replace the planar target with a hollow cylindrical one comprising, or having the outer surface coated with, the material to be sputtered. In a cylindrical magnetron apparatus (sold by BOC Coating Technology, a Division of the Applicants under the trade mark "C-Mag") an array of permanent magnets is generally held stationary within the cylindrical target whilst (in use) the latter rotates continuously or intermittently so that sputtering is not confined to one particular area of the target surface.

As with the planar magnetron apparatus, the substrate being coated is moved, again either continuously or intermittently, relative to the target, usually in a direction transverse to the longitudinal axis of the cylindrical target.

Both planar magnetron and cylindrical magnetron apparatus can be used to deposit alloy coatings or other mixed coatings, for example either by having a target whose erosion surface is made from the alloy or whatever and/or having a reactive gas such as oxygen present in the sputtering chamber and which is incorporated in to the coating in ways known per se.

In the deposition of alloy or other mixed coatings by sputtering, however, there can be problems in producing coatings of uniform composition across the substrate and this can obviously detract from the properties of the coating and uses to which the coated product can be put.

In the case of cylindrical magnetron apparatus in particular, it is possible to use two targets of different compositions, for example use of one metal and one of another metal, and for the coating produced to be a mixture of the different target materials.

Although such an approach affords greater flexibility in producing the final coating, problems of ensuring a uniform composition throughout the coating can still remain.

The present invention is concerned with improved sputtering processes in which such problems can generally be minimised or overcome.

In accordance with the invention, there is provided a process for coating a substrate by sputtering in a vacuum chamber from a target, which comprises forming a plasma in the chamber in the vicinity of the target and applying an electric charge to the target, wherein the target surface from which the sputtering takes place comprises a plurality of areas of different composition and separate electrical connections are made to each area to enable a variable electric charge to be applied to each individual area.

The invention therefore provides means to allow a precise control of the coating being produced by being able to vary the electric charge, and therefore vary the attraction to the plasma ions, with respect to each different area of the target surface and, in particular, to do this during the course of the process.

As such, any modifications required to the coating composition during the process; for example:
- to correct any identified unwanted variations of the composition as a whole or in certain parts of the substrate surface
- to cause desired variations of composition as the process proceeds from the initial layers being deposited to the later layers
- to cause desired variations of composition as the process proceeds in different parts of the substrate surface.

In preferred embodiments of the invention, sensors. for example optical emission sensors, can be employed to detect one or more (preferably all) of the individual components of an alloy or other mixed composition coating. Generally, such sensors would advantageously detect and analyse the excited species dislodged from the target surface as the excited species approach the substrate surface. If needed, different sensors for the same component can be positioned at a number of places across the substrate surface.

Preferably the sensors are linked to the electric supply system for applying the variable electric charge to the individual target areas. Advantageously the supply system is pre-programmed to allow for corrections to be made to the coating composition to correct the composition being deposited or modify the composition during the process in the ways described above, al in response to the output from the sensors.

The target used in the process of the invention must have at least two areas of different composition to which separate electrical connections are made. Preferably however, the target has several areas with separate electrical connections. For example, for a two-phase alloy, there can usefully be about six separate areas, ie three of each component; for a three-phase alloy, there can usefully be about nine separate areas, ie again three for each component.

The invention is particularly applicable to targets which are planar or at least substantially planar.

In preferred embodiments, different target areas can be formed from individual tiles of the different components which are inserted and held in a target framework via which the individual electrical connections are effected. Such an arrangement allows for ready replacement of the individual tiles when required.

For a better understanding of the invention, reference will now be made, by way of exemplification only, to the following drawings in which:

Figure 1 shows a schematic representation of an apparatus for carrying out the process of the invention.

Figure 2 shows a cross sectional view of the target as part of the apparatus of Figure 1.

Figure 3 shows a plan view of the target shown in Figure 2.

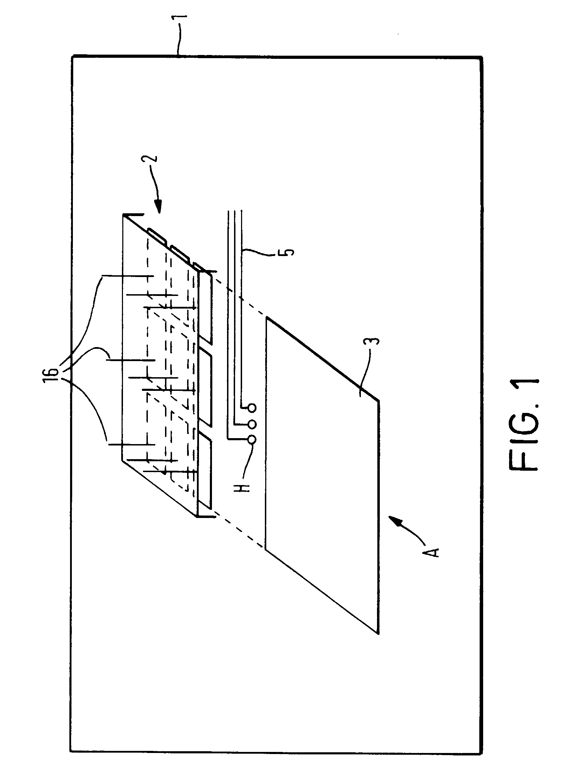

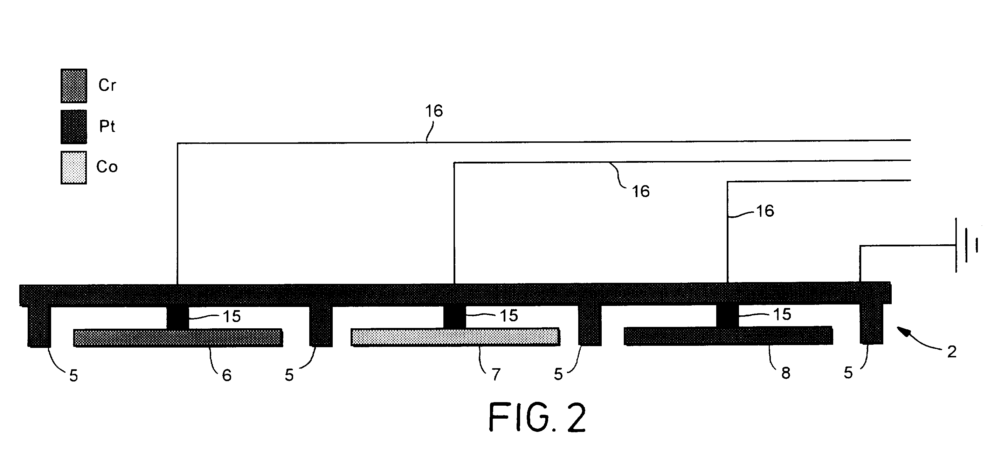

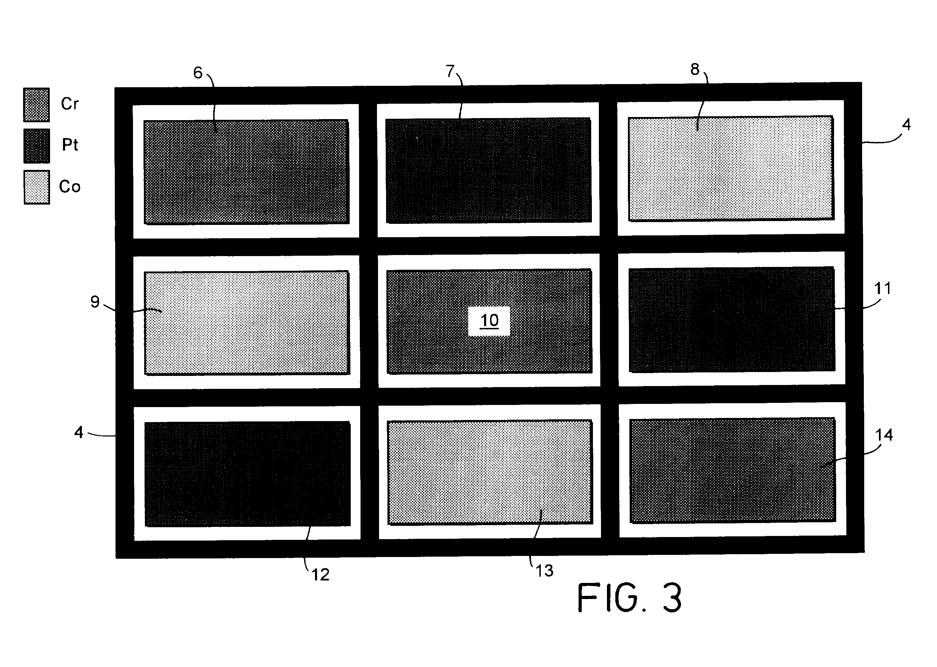

With reference to the drawings and in particular to Figure 1, there is shown a vacuum chamber 1 having fixed therein a target generally shown at 2 and described in more detail below with reference to Figure 2 and 3.

The chamber 1 is adapted to allow the passage of a substrate 3 through the chamber in a substantially horizontal plane in the direction indicated by the arrow A and in particular to pass beneath the lower surface of the target 2. The substrate may be a continuous one or may alternatively comprise a number of individual substrates passing through the chamber in succession.

A number of optical emission sensors S each having a sensor head H are positioned between the target 2 and the substrate 3 such that the sensor heads 5 are close to the upper surface of the substrate whilst coating is taking place.

Turning to Figures 2 and 3, the target 2 comprises an upper frame 4 of substantially rectangular cross section and made of metal, for example steel, stainless steel or aluminium, from which depends a flange structure whose component flanges 5 define nine rectangular cavities on the lower side of the upper frame 4.

Within each cavity is positioned a plate 6, 7, 8, 9, 10, 11, 12, 13, 14 made from a substance being a component (or components) of the desired coating on the substrate. The individual plates are held in position and electrically insulated from the upper frame 4 by means of rods 15 of insulating material.

For example, if a three component alloy of chromium, platinum and cobalt is required, the plates 6,10 and 14 could be made of chromium, plates 7,11,12 could be made of platinum and the plates 8, 9, 13 could be made of cobalt.

Individual electrical connections 16 are made to each of the nine plates via leads passing through the insulating rods 15 to enable a variable electrical charge to be effected to each plate independently of the other plates.

In use of the apparatus described above with reference to Figures 1 to 3 for carrying out a process of the invention, argon gas is introduced in to the chamber which had previously been evacuated down to for example 1 x 10⁻³ or lower, mbar and an argon ion plasma formed in situ through the charging of the target.

The plates 6 to 14 are individually charged, initially at substantial the same size of electric charge and a substrate 3 or substrates passed under the target in the direction of the arrow A such that the upper surface of the substrate 3 and the lower surfaces of the plates 6 to 14 are substantially parallel but spaced apart in the usual way.

Interposed between the substrate 3 and the target 4 are the sensor heads 5 which can sense the amount of the individual species present close to the surface of the substrate 3 as they pass from plates 6 to 14 to the upper surface of the substrate 3

Means (not shown) are provided to link the sensors' output to the electrical connections 16 such that the size of the electron charge on each plate, or alternating on each set of plate of the same composition, is varied when the sensors indicate a change in the amounts of the species approaching the substrate away from a desired, predetermined composition.

The invention may also be used such that the composition of coating across the substrate surface varies by applying different electrical charges to different plates across the surface of the target.

In certain uses of the invention, the substrate 3 may be held stationary relative to the target 2.

## Claims

1. A process for coating a substrate by sputtering in a vacuum chamber from a target, which comprises forming a plasma in the chamber in the vicinity of the target and applying an electric charge to the target, wherein the target surface from which the sputtering takes place comprises a plurality of areas of different composition and separate electrical connections are made to each area to enable a variable electric charge to be applied to each individual area.

2. A process according to Claim 1 in which sensors are employed to detect one or more of the individual components of an alloy or other mixed composition coating at a position between the target and substrate surfaces.

3. A process according to Claim 2 in which the sensors are linked to the electric supply system for applying the variable electric charge to the individual target areas.

4. A process according to Claim 3 in which the electric supply system is pre-programmed to allow for corrections to be made to the coating composition to correct the composition being deposited or modify the composition during the process in response to the output from the sensors.

5. A process according to any preceding Claim in which the target has about six target areas for depositing a two-phase alloy.

6. A process according to any one of Claims 1 to 5 in which the target has about nine target areas for depositing a three-phase alloy.

7. A process according to any preceding Claim in which the different target areas are formed from individual tiles of the different compositions which are mounted and held in a target framework via which the individual electrical connections are effected.
